(19) Europäisches Patentamt
European Patent Office
Office européen des brevets

(11) **EP 2 823 568 B1**

(12) **EUROPÄISCHE PATENTSCHRIFT**

(45) Veröffentlichungstag und Bekanntmachung des Hinweises auf die Patenterteilung:
**21.02.2018  Patentblatt 2018/08**

(21) Anmeldenummer: **13726471.9**

(22) Anmeldetag: **24.05.2013**

(51) Int Cl.:
*H03M 7/30* (2006.01)       *H03M 7/40* (2006.01)
*H03M 7/42* (2006.01)

(86) Internationale Anmeldenummer:
**PCT/EP2013/060698**

(87) Internationale Veröffentlichungsnummer:
**WO 2014/001001 (03.01.2014 Gazette 2014/01)**

(54) **VERFAHREN ZUR CODIERUNG EINES DATENSTROMS**

METHOD FOR CODING A DATA STREAM

PROCÉDÉ DE CODAGE D'UN FLUX DE DONNÉES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.06.2012  DE 102012211031**

(43) Veröffentlichungstag der Anmeldung:
**14.01.2015  Patentblatt 2015/03**

(73) Patentinhaber: **Siemens Aktiengesellschaft**
**80333 München (DE)**

(72) Erfinder: **LAUTHER, Ulrich**
**80686 München (DE)**

(56) Entgegenhaltungen:
• **FARSHID GOLCHIN ET AL: "Minimum-entropy clustering and its application to lossless image coding", PROCEEDINGS OF INTERNATIONAL CONFERENCE ON IMAGE PROCESSING, Bd. 2, 26. Oktober 1997 (1997-10-26), Seiten 262-265, XP055070477, DOI: 10.1109/ICIP.1997.638738 ISBN: 978-0-81-868183-7**

**Beschreibung**

Die Erfindung betrifft ein Verfahren zur Codierung eines Datenstroms, der eine Vielzahl von Zeichen umfasst, welche Symbole aus einem Alphabet darstellen, sowie eine entsprechende Codiereinrichtung und eine Sendevorrichtung. Ferner betrifft die Erfindung ein Verfahren und eine Vorrichtung zur Übertragung eines Datenstroms.

Aus dem Stand der Technik ist es bekannt, einen Datenstrom verlustlos über eine sog. Entropiecodierung zu komprimieren. Dabei werden solchen Symbolen des Datenstroms, welche häufiger vorkommen, kürzere Codes zugeordnet, so dass die Gesamtlänge des codierten Datenstroms reduziert wird. Die Zuordnung der entsprechenden Symbole zu Codes erfolgt basierend auf einer Code-Tabelle, welche den Symbolen die entsprechenden Codes zuweist. Da die Häufigkeit von Symbolen in verschiedenen Abschnitten eines Datenstroms unterschiedlich sein kann, können ggf. verschiedene Code-Tabellen für unterschiedliche Abschnitte bzw. Blöcke des Datenstroms verwendet werden. Da die Code-Tabellen zur Decodierung des Datenstroms an den entsprechenden Decodierer übertragen werden müssen, ist es wünschenswert, deren Anzahl geeignet zu beschränken. Es besteht somit das Bedürfnis, eine effiziente Codierung eines Datenstroms mit einer beschränkten Anzahl an Code-Tabellen zu erreichen.

Das Dokument Farshid Golchin et al: "Minimum-entropy clustering and ist application to lossless image coding", PROC. OF INT. CONF. ON IMAGE PROCESSING, Bd. 2, 26. Oktober 1997, Seiten 262-265, offenbart eine Entropie-Codierung, bei der die zu codierenden Blöcke iterativ Clustern zugeordnet werden, wobei die Zuweisung zu den Clustern derart erfolgt, dass die Entropie des jeweiligen Clusters möglichst klein ist. Die Blöcke, die zu dem jeweiligen Cluster gehören, werden basierend auf der Wahrscheinlichkeitsverteilung der Symbole in dem jeweiligen Cluster entropiecodiert.

Aufgabe der Erfindung ist es, einen Datenstrom verlustlos mit einer hohen Kompressionsrate unter Verwendung von Code-Tabellen zu codieren.

Diese Aufgabe wird durch die unabhängigen Patentansprüche gelöst. Weiterbildungen der Erfindung sind in den abhängigen Ansprüchen definiert.

Das erfindungsgemäße Verfahren dient zur Codierung eines Datenstroms mit einer Vielzahl von Zeichen, welche Symbole aus einem Alphabet darstellen. Beispielsweise können die Zeichen entsprechende ASCII-Symbole sein, die über geeignete Bitsequenzen im Datenstrom repräsentiert werden. Die Zeichen des Datenstroms sind in eine Mehrzahl von Blöcken aus mehreren aufeinander folgenden Zeichen des Datenstroms zusammengefasst. Dabei werden die Blöcke basierend auf einer für den jeweiligen Block gültigen Code-Tabelle entropiecodiert.

Im Rahmen des erfindungsgemäßen Verfahrens werden die Blöcke über eine Iteration einer Mehrzahl von Clustern basierend auf einem Abstandsmaß zugeordnet, welches derart definiert ist, dass das Abstandsmaß zwischen einem Block und einem Cluster umso kleiner ist, je geringer die (betragsmäßige) Veränderung bzw. Zunahme der Entropie des Clusters bei der Hinzunahme des Blocks zu dem Cluster ist. Dabei erfolgt in einem jeweiligen Iterationsschritt der Iteration eine Neuzuordnung der Blöcke zu den Clustern, indem die Blöcke jeweils dem Cluster mit dem geringsten Abstand zwischen Block und Cluster zugeordnet werden. Das Abstandsmaß zwischen einem Block und einem Cluster, dem gerade der Block zugeordnet ist, wird dabei derart bestimmt, dass das Abstandsmaß zwischen dem Block und dem Cluster ohne diesen Block ermittelt wird.

Der obige Begriff der Entropie ist dem Fachmann hinlänglich bekannt. Die Entropie ist das Maß für den mittleren Informationsgehalt der in einem Cluster verwendeten Zeichen, die Symbole aus einem Alphabet sind. Die Entropie ist dabei für ein Cluster aus einem oder mehreren Blöcken, der insgesamt n Zeichen aus einer Menge von Symbolen s umfasst, wie folgt definiert:

$$ET = -\sum_s f(s) * \log_2\left(f(s)/n\right),$$

wobei ET die Entropie bezeichnet;
wobei über die im Cluster auftretenden Symbole s summiert wird;
wobei f(s) die Häufigkeit des entsprechenden Symbols s im Cluster bezeichnet.

Im erfindungsgemäßen Verfahren wird den durch die Iteration bestimmten Clustern jeweils eine Code-Tabelle zugeordnet, welche basierend auf der Häufigkeitsverteilung der Symbole in zumindest einem Teil der in dem jeweiligen Cluster enthaltenen Blöcke und insbesondere der Symbole in allen in dem jeweiligen Cluster enthaltenen Blöcke bestimmt wird und für alle Blöcke des jeweiligen Clusters gültig ist.

Mit dem erfindungsgemäßen Verfahren wird über ein geeignetes Entropie-basiertes Abstandsmaß eine Zusammenfassung von Blöcken mit ähnlicher Häufigkeitsverteilung zu Clustern erreicht, so dass über entsprechend bestimmte Code-Tabellen für die Blöcke eines Clusters eine verlustlose Entropiecodierung mit hoher Kompressionseffizienz erreicht wird. Dabei wird die Clusterung basierend auf einer Iteration erreicht, welche an den aus dem Stand der Technik bekannten k-means-Algorithmus angelehnt ist, der nunmehr erstmalig mit einem Entropiebasierten Abstandsmaß im Bereich der Datencodierung eingesetzt wird.

Erfindungsgemäß wird die Iteration derart initialisiert, dass eine Mehrzahl von Clustern aus jeweils einem Block ermittelt wird und anschließend die restlichen Blöcke, d.h. die Blöcke, welche noch keinen Clustern zugeordnet sind, jeweils dem Cluster mit dem geringsten Abstandsmaß zwischen Block und Cluster zugeordnet werden. Die Mehrzahl von Clustern entspricht dabei k Clustern ($k \geq 2$). Dabei ist k die konstant vorgegebene Anzahl der zu bildenden Cluster und entspricht somit der Anzahl an Code-Tabellen.

In einer einfachen, nicht zur Erfindung gehörigen Variante der obigen Initialisierung der Iteration wird die Mehrzahl von Clustern aus jeweils einem Block zufällig ermittelt. Erfindungsgemäß wird zunächst der Block mit der kleinsten Entropie im Datenstrom ermittelt und es wird ein Cluster aus diesem Block gebildet, wobei anschließend schrittweise Blöcke ermittelt werden, deren minimales Abstandsmaß zu den bereits vorhandenen Clustern maximal ist, wobei für einen ermittelten Block ein weiterer Cluster aus diesem ermittelten Block gebildet wird, bis die Anzahl von Clustern aus jeweils einem Block vorliegt.

In einer Ausführungsform des erfindungsgemäßen Verfahrens wird in jedem Iterationsschritt die Gesamtentropie als Summe der Entropien aller Cluster bestimmt und die Iteration abgebrochen, wenn der Unterschied zwischen der im jeweiligen Iterationsschritt bestimmten Gesamtentropie und der im vorhergehenden Iterationsschritt bestimmten Gesamtentropie geringer als eine vorbestimmte Schwelle ist. Zusätzlich oder alternativ kann als Abbruchkriterium der Iteration eine maximale Anzahl an Iterationsschritten vorgegeben sein, wobei die Iteration abgebrochen wird, wenn die maximale Anzahl an Iterationsschritten überschritten wird.

Die im Rahmen des erfindungsgemäßen Verfahrens durchgeführte Entropiecodierung mit Hilfe von Code-Tabellen kann auf einem beliebigen Verfahren zur verlustlosen Codierung beruhen. In einer bevorzugten Variante erfolgt die Entropiecodierung mit der an sich bekannten Huffman-Codierung.

Das erfindungsgemäße Verfahren kann zur Codierung von beliebigen Datenströmen eingesetzt werden. In einer Variante der Erfindung enthält der Datenstrom Software-Aktualisierungs-Daten, insbesondere für ein Mobiltelefon. Mit diesen Daten kann die Software eines entsprechenden Geräts auf den aktuellen Stand gebracht werden. Die Software-Aktualisierungs-Daten enthalten dabei vorzugsweise die Differenz zwischen der alten Software und der neuen aktuellen Software.

Neben dem oben beschriebenen Codierverfahren betrifft die Erfindung ferner eine Codiereinrichtung zur Codierung eines Datenstroms, wobei der Datenstrom eine Vielzahl von Zeichen umfasst, welche Symbole aus einem Alphabet sind, wobei die Zeichen des Datenstroms in eine Mehrzahl von Blöcken zusammengefasst sind. Die Codiereinrichtung ist zur Entropiecodierung der Blöcke basierend auf einer für den jeweiligen Block gültigen Code-Tabelle vorgesehen.

Die erfindungsgemäße Codiereinrichtung umfasst ein erstes Mittel, um die Blöcke über eine Iteration einer Mehrzahl von Clustern basierend auf einem Abstandsmaß zuzuordnen, welches derart definiert ist, dass das Abstandsmaß zwischen einem Block und einem Cluster umso kleiner ist, je geringer die Zunahme der Entropie des Clusters bei der Hinzunahme des Blocks zu dem Cluster ist, wobei in einem jeweiligen Iterationsschritt der Iteration eine Neuzuordnung der Blöcke zu den Clustern erfolgt, indem die Blöcke jeweils dem Cluster mit dem geringsten Abstandsmaß zwischen Block und Cluster zugeordnet werden. Die Codiereinrichtung umfasst ferner ein zweites Mittel, um den durch die Iteration bestimmten Clustern jeweils eine Code-Tabelle zuzuordnen, welche mit dem zweiten Mittel basierend auf der Häufigkeitsverteilung der Symbole in zumindest einem Teil der in dem jeweiligen Cluster enthaltenen Blöcke und insbesondere der Symbole in allen in dem jeweiligen Cluster enthaltenen Blöcke bestimmt wird und für alle Blöcke des jeweiligen Clusters gültig ist. Die erfindungsgemäße Codiereinrichtung ist zur Durchführung des erfindungsgemäßen Verfahrens ausgestaltet.

Die erfindungsgemäße Codiereinrichtung ist vorzugsweise derart ausgestaltet, dass eine oder mehrere der bevorzugten Varianten des erfindungsgemäßen Verfahrens mit der Codiereinrichtung durchführbar sind.

Die Erfindung betrifft ferner ein Verfahren zum Aussenden eines Datenstroms, wobei der Datenstrom mit dem oben beschriebenen erfindungsgemäßen Verfahren codiert wird. Anschließend werden der codierte Datenstrom sowie die entsprechend ermittelten Code-Tabellen für die Mehrzahl von Clustern und die Information, für welche Blöcke die Code-Tabellen gültig sind, ausgesendet.

Die Erfindung betrifft darüber hinaus eine Sendevorrichtung zum Aussenden eines Datenstroms umfassend die oben beschriebene erfindungsgemäße Codiereinrichtung sowie ein Mittel zum Aussenden des mit der Codiereinrichtung codierten Datenstroms und der Code-Tabellen für die Mehrzahl von Clustern und der Information, für welche Blöcke die Code-Tabellen gültig sind.

Die Erfindung betrifft ferner ein Verfahren zur Übertragung eines Datenstroms, wobei der Datenstrom mit dem oben beschriebenen erfindungsgemäßen Sendeverfahren ausgesendet wird und von einer Empfangsvorrichtung empfangen wird, welche den codierten Datenstrom mit Hilfe der Code-Tabellen für die Mehrzahl von Clustern und der Information, für welche Blöcke die Code-Tabellen gültig sind, decodiert.

Die Erfindung betrifft darüber hinaus eine Vorrichtung zur Übertragung eines Datenstroms umfassend die oben beschriebene erfindungsgemäße Sendevorrichtung zum Aussenden des Datenstroms sowie eine Empfangsvorrichtung mit einem Empfangsmittel zum Empfangen des codierten Datenstroms und der Code-Tabellen für die Mehrzahl von Clustern und der Information, für welche Blöcke die Code-Tabellen gültig sind. Die Empfangsvorrichtung umfasst ferner eine Decodiereinrichtung zum Decodieren des codierten Datenstroms mit Hilfe der Code-Tabellen und der Information, für welche Blöcke die Code-Tabellen gültig sind.

Ausführungsbeispiele der Erfindung werden nachfolgend anhand der beigefügten Figuren detailliert beschrieben.

Es zeigen:

Fig. 1 eine schematische Darstellung der im Rahmen des erfindungsgemäßen Verfahrens durchgeführten Bestimmung von Clustern; und

Fig. 2 eine schematische Darstellung eines Systems, in dem ein Datenstrom basierend auf dem erfindungsgemäßen Verfahren von einer Sendevorrichtung codiert und ausgesendet wird und anschließend in einer Empfangsvorrichtung empfangen und decodiert wird.

Im Rahmen der hier beschriebenen Ausführungsform des erfindungsgemäßen Verfahrens wird ein Datenstrom, der eine Vielzahl von Zeichen in der Form von Symbolen aus einem Alphabet (z.B. ASCII-Symbole) repräsentiert, mittels einer verlustlosen Entropiecodierung codiert. Dabei wird eine Mehrzahl von aufeinander folgenden Zeichen im Datenstrom zu Blöcken zusammengefasst, wobei jeder Block mit einer entsprechenden Code-Tabelle entropiecodiert wird. Über seine Code-Tabelle werden dabei den Symbolen entsprechende Codewörter basierend auf der Häufigkeitsverteilung der Symbole zugeordnet. Das heißt, je weniger häufig ein Symbol im entsprechenden Block ist, desto kürzer ist das Codewort. Diese verlustlose Entropiecodierung ist an sich aus dem Stand der Technik bekannt und in einer bevorzugten Ausführungsform wird die Huffman-Codierung verwendet. Erfindungswesentlich ist nunmehr, dass mehrere Blöcke mit ähnlicher Häufigkeitsverteilung in geeigneter Weise zu Clustern zusammengefasst werden und immer nur für einen jeweiligen Cluster eine Code-Tabelle erstellt wird. Auf diese Weise kann eine effiziente Codierung mit maximaler Kompression erreicht werden.

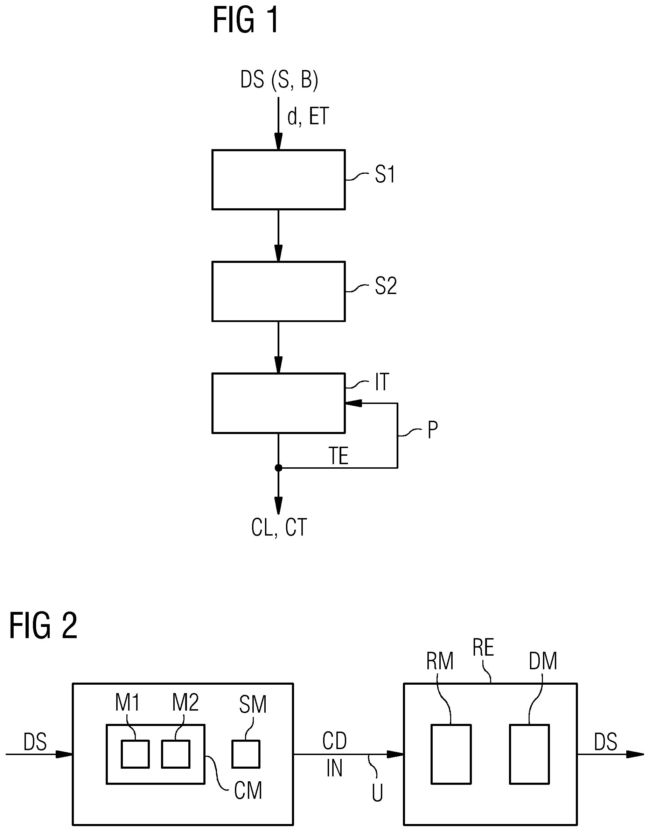

Im Folgenden wird anhand von Fig. 1 die Zuordnung der einzelnen Blöcke des Datenstroms zu Clustern beschrieben. Als Eingangsgröße wird der Datenstrom DS verarbeitet, der entsprechende Zeichen in der Form von Symbolen S enthält, die zu einer Mehrzahl von Blöcken B zusammengefasst sind. Im Rahmen des hier beschriebenen Verfahrens werden ein entsprechendes Abstandsmaß d sowie eine Entropie ET berücksichtigt, über welche die Zuordnung von Blöcken zu Clustern erreicht wird, wie im Folgenden näher erläutert wird. Die Zuordnung der Blöcke zu Clustern ist an den aus dem Stand der Technik bekannten k-means-Algorithmus angelehnt, der erstmalig im Bereich der Entropiecodierung sowie basierend auf einem besonderen, entropieabhängigen Abstandsmaß eingesetzt wird.

Allgemein ist es das Ziel des k-means-Algorithmus, die Summe der Abstände von Objekten zum Schwerpunkt ihres jeweiligen Clusters zu minimieren. In mehreren Iterationsschritten wird dazu jedes Objekt dem Cluster zugeordnet, dessen Schwerpunkt es am nächsten liegt. Am Ende jedes Iterationsschritts werden die Clusterschwerpunkte (Mittelwert der entsprechenden Objekte im Cluster) neu berechnet. Hierzu ist eine geeignete Abstandsdefinition erforderlich. Im Rahmen des erfindungsgemäßen Verfahrens werden die Objekte nunmehr durch die entsprechenden Blöcke im zu codierenden Datenstrom repräsentiert und der Abstand wird basierend auf der betragsmäßigen Zunahme der Entropie eines Clusters bei der Hinzunahme eines Blocks zu dem Cluster definiert. Mit einer derartigen Entropiebasierten Abstandsfunktion werden Blöcke mit ähnlicher Häufigkeitsverteilung der Symbole zusammengefasst, so dass die Verwendung der gleichen Code-Tabelle für Blöcke eines Clusters zu einer besonders guten Kompression führt.

Die Entropie eines Blocks bzw. eines Clusters ist eine hinlänglich aus dem Stand der Technik bekannte Größe und stellt eine Unterschranke für die Komprimierbarkeit der entsprechenden Symbole im Block bzw. Cluster dar. Bei einem hohen Entropiewert weisen alle im Block bzw. Cluster auftretenden Symbole eine ähnliche Häufigkeit auf. Demgegenüber treten bei einem niedrigen Entropiewert wenige Symbole mit großer Häufigkeit auf.

Mathematisch kann die Entropie ET eines Blocks bzw. eines Clusters aus n Zeichen, die jeweils durch ein entsprechendes Symbol s dargestellt sind, basierend auf der Häufigkeit f(s) eines im Block bzw. Cluster enthaltenen Symbols s wie folgt beschrieben werden:

$$ET = -\sum_s f(s) * \log(f(s)/n) \qquad (1).$$

Hier und im Folgenden bezeichnet log den Logarithmus zur Basis 2. Dabei wird über alle im Block bzw. Cluster auftretenden Symbolen s summiert. Äquivalent zu dieser Gleichung kann die Entropie auch wie folgt geschrieben werden:

$$ET = n\log(n) - \sum_s f(s) * \log(f(s)) \qquad (2).$$

Wird nunmehr ein Block b aus $n_b$ Zeichen zu einem Cluster c aus $n_c$ Zeichen hinzugefügt, so wächst die kombinierte Entropie um den folgenden Betrag:

$$\delta_{c,b} = (n_c + n_b)\log(n_c + n_b) - (n_c)\log(n_c) -$$
$$\sum_{s_b} \left( (f_c(s_b) + f_b(s_b))\log(f_c(s_b) + f_b(s_b)) - f_c(s_b)\log(f_c(s_b)) \right) \qquad (3).$$

$f_b(s_b)$ entspricht der Häufigkeit eines entsprechenden, im Block b auftretenden Symbols $s_b$ im Block b und $f_c(s_b)$ entspricht der Häufigkeit eines entsprechenden, im Block b auftretenden Symbols $s_b$ im Cluster c. Dabei entfällt der letzte Term aus obiger Gleichung, falls $f_c(s_b)=0$ gilt. Die obige Größe $\delta_{c,b}$ stellt die Veränderung der Entropie eines Clusters c bei der Hinzunahme des Blocks b zum Cluster c dar und ist eine Ausführungsform eines Abstandsmaßes im Sinne der Patentansprüche. In Fig. 1 ist dieses Abstandsmaß mit Bezugszeichen d bezeichnet. Das soeben beschriebene Abstandsmaß $\delta_{c,b}$ wird in der weiter unten beschriebenen Iteration gemäß dem k-means-Algorithmus eingesetzt.

Gemäß Fig. 1 wird vor der eigentlichen Durchführung der an den k-means-Algorithmus angelehnten Iteration IT eine geeignete Initialisierung in den Schritten S1 und S2 durchgeführt. Basierend auf einer vorgegebenen Anzahl k von zu erstellenden Code-Tabellen werden im ersten Schritt S1 der Initialisierung zunächst k Cluster aus jeweils einem einzelnen Block gebildet. In der hier beschriebenen Ausführungsform wird dabei nach solchen Blöcken gesucht, die entsprechend dem obigen Abstandsmaß $\delta_{c,b}$ weit auseinander liegen. Dabei wird zunächst nach demjenigen Block in dem Datenstrom gesucht, der die kleinste Entropie aufweist. Dieser Block bildet den ersten Cluster. Danach wird (k-1)-mal nach einem Block gesucht, dessen minimaler Abstand zu bereits gebildeten Clustern maximal ist. Aus diesem Block wird ein neuer Cluster gebildet.

Der soeben beschriebene Schritt S1 und auch die weiteren Verfahrensschritte werden im Folgenden durch geeignete Pseudo-Codes dargestellt. Kommentare in den Pseudo-Codes werden durch zwei Schrägstriche repräsentiert. Die Größe entropie(b) in den Pseudo-Codes entspricht der oben definierten Entropie ET für einen entsprechenden Block b. Ebenso entspricht die Größe distance(b, c) dem oben definierten Abstandsmaß d bzw. $\delta_{c,b}$ zwischen einem Block b und einem Cluster c.

Der Pseudo-Code für den obigen Schritt S1 lautet wie folgt:

```
Erstelle Liste aus freien Blöcken, die keinen Clustern zuge-
ordnet sind;
min_entropie = ∞;
für alle Blöcke b aus der Liste {
        e = entropie (b);
        falls (e < min_entropie) {
                min_entropie = e;
                min_block = b;
        }
}
```

```
Erstelle Cluster c₁ enthaltend Block min_block;
Lösche min_block aus der Liste der freien Blöcke;

max_dist = 0;
für (i = 2 bis k) {
        //Finde freien Block aus der Liste mit maximalem
        //kleinsten Abstandsmaß zu den Clustern:
        für alle freien Blocks b {
        //Finde kleinstes Abstandsmaß zu den Clustern:
            min_dist = ∞;
            für alle Cluster c {
                d = distance (b, c);
                falls (d < min_dist) {
                    min_dist = d;
                    min_block = b;
                    }
            }
            falls (min_dist > max_dist) {
                max_dist = min_dist;
                max_block = min_block;
            }
        }
        Erstelle Cluster cᵢ enthaltend Block max_block;
        Lösche max_block aus Liste der freien Blöcke;
    }
```

Man erhält somit nach Durchführung des Schritts S1 k Cluster mit jeweils einem Block. In Schritt S2 werden nunmehr die restlichen, noch nicht zu Clustern zugeordneten Blöcke dem Cluster mit dem geringsten Abstandsmaß zum jeweiligen Block zugewiesen. Dies wird basierend auf folgendem Pseudo-Code erreicht:

```
        min_dist = ∞;
        für alle freien Blöcke b {
            für alle Cluster c {
                d = distance (b, c);
```

```
        falls (d < min_dist) {
            min_dist = d;
            min_cluster = c;
        }
    }
    Füge Block b zum Cluster min_cluster hinzu;
}
```

Nach Schritt S2 folgt schließlich die eigentliche Iteration IT. Dabei wird in jedem Iterationsschritt eine Neuzuordnung der Blöcke zu den Clustern durchgeführt, indem für jeden Block der nächstliegende Cluster basierend auf dem Entropiebasierten Abstandsmaß ermittelt und in diesen Cluster verschoben wird. Zur Bestimmung des Abstandsmaßes zwischen einem Block und dem Cluster, in dem sich der Block aktuell befindet, wird dabei das Abstandsmaß zwischen dem Block und dem Cluster bei Herausnahme des Blocks aus dem Cluster bestimmt. Nach der Durchführung eines jeweiligen Iterationsschritts haben sich die Cluster verändert, so dass sich im nächsten Iterationsschritt Unterschiede in der Zuordnung der Blöcke zu den Clustern ergeben können.

Die iterative Neuzuordnung der Blöcke zu Clustern kann durch folgenden Pseudo-Code repräsentiert werden, wobei die nachfolgende While-Schleife solange durchlaufen wird, wie die Variable change auf dem Zustand true gesetzt ist:

```
change = true;
iter = 0;
solange (change) {
    change = false;
    iter = iter + 1;
    Berechne Gesamtentropie old_entropie;
    für alle Blöcke b {
        old_cluster = Cluster von b;
        min_dist = ∞;
        für alle Cluster c {
```

```
            d = distance (b, c);
            falls (d < min_dist) {
                min_dist = d;
                min_cluster = c;
            }
        }
        falls (min_cluster != old_cluster) {
            Verschiebe Block b vom old_cluster zu
            new_cluster;
            change = true;
        }
    }
    Berechne Gesamtentropie new_entropie;
    falls (|new_entropie − old_entropie| < epsilon || iter >
    max_iter) change = false;
}
```

Im obigen Pseudo-Code wird die Gesamtentropie basierend auf der Summe der Entropien aller, im jeweiligen Iterationsschritt bestimmter Cluster ermittelt. Dabei repräsentiert new_entropy die im aktuellen Iterationsschritt ermittelte Gesamtentropie und old_entropy die im vorhergehenden Iterationsschritt ermittelte Gesamtentropie. Die im aktuellen Iterationsschritt bestimmte Entropie, welche in Fig. 1 mit TE bezeichnet ist, wird als ein Abbruchkriterium für die Iteration IT verwendet, was in Fig. 1 durch den Pfeil P angedeutet ist. Sollte diese aktuelle Entropie weniger als ein vorbestimmter Schwellwert (im Pseudo-Code als "epsilon" bezeichnet) von der Gesamtentropie des vorhergehenden Iterationsschritts abweichen, wird die Iteration IT beendet, da sich keine bzw. nur noch geringfügige Änderungen in der Gesamtentropie ergeben. Als weiteres Abbruchkriterium wird gemäß dem obigen Pseudo-Code eine maximale Anzahl an Iterationen max_iter verwendet. Wird diese maximale Anzahl an Iterationen überschritten, wird die Iteration IT ebenfalls abgebrochen.

Als Ergebnis des oben beschriebenen Verfahrens erhält man eine Anzahl von k Clustern, welche in Fig. 1 mit CL bezeichnet sind. Jedem Cluster sind dabei entsprechende Blöcke aus dem Datenstrom zugeordnet. Alle Blöcke, die zu dem gleichen Cluster gehören, werden mit der gleichen Code-Tabelle entropiecodiert. Demzufolge werden in einem nächsten Schritt des Verfahrens, der nicht mehr in Fig. 1 gezeigt ist, basierend auf den Häufigkeitsverteilungen der Symbole in den zu einem jeweiligen Cluster gehörigen Blöcken in an sich bekannter Weise Code-Tabellen erstellt, die in Fig. 1 allgemein mit CT bezeichnet sind. Mit diesen Code-Tabellen werden dann den Symbolen in den Blöcken Codewörter zugeordnet, wodurch die Entropiecodierung des Datenstroms erreicht wird. Der codierte Datenstrom kann dann über eine entsprechende Übertragungsstrecke zusammen mit den Code-Tabellen und den Zuordnungen der Blöcke zu den Code-Tabellen übertragen werden und von einem Empfänger mit Hilfe der Code-Tabellen und der entsprechenden Zuordnung der Blöcke zu den Tabellen decodiert werden. Ein entsprechendes Szenario ist in Fig. 2 dargestellt.

Fig. 2 zeigt ein System, gemäß dem der ursprüngliche Datenstrom DS codiert, über eine Übertragungsstrecke übertragen und anschließend decodiert wird. Der Datenstrom DS wird dabei von einer Sendevorrichtung SE verarbeitet. Diese Sendevorrichtung SE umfasst eine Codiereinrichtung CM mit entsprechenden Mitteln M1 und M2 zur Durchführung des erfindungsgemäßen Verfahrens. Im Mittel M1 werden die entsprechenden Cluster im Rahmen der oben beschriebenen Iteration bestimmt. Im Mittel M2 werden dann die geeigneten Code-Tabellen basierend auf den Häufigkeitsverteilungen der Symbole in den Clustern ermittelt und den entsprechenden Blöcken zugeordnet. Mit diesen Code-Tabellen erfolgt dann die Entropiecodierung in der Codiereinrichtung CM. Der hierdurch erzeugte codierte Datenstrom CD wird anschließend zusammen mit einer Zusatzinformation IN über ein entsprechendes Sendemittel SM der Sendevorrichtung SE ausgesendet und über eine Übertragungsstrecke U übertragen. Das Sendemittel SM kann z.B. eine Antenne umfassen, so dass der codierte Datenstrom CD und die Information IN drahtlos übermittelt werden. Die Information IN enthält die entsprechend bestimmten Code-Tabellen sowie die Zuordnung der Blöcke des Datenstroms zu den Code-Tabellen.

Der Datenstrom CD und die Information IN werden schließlich von einer Empfangsvorrichtung RE über ein entsprechendes Empfangsmittel RM empfangen. Das Empfangsmittel kann bei einer drahtlosen Übertragung eine entsprechende Empfangsantenne umfassen. Anschließend erfolgt in einer Decodiereinrichtung DM die Decodierung des codierten Datenstroms unter Verwendung der in der Information IN enthaltenen Code-Tabellen und deren Zuordnung zu den Blöcken. Schließlich erhält man wieder den ursprünglichen Datenstrom DS, der aufgrund der Entropiecodierung verlustlos wiederhergestellt werden kann.

Die im Vorangegangenen beschriebenen Varianten des erfindungsgemäßen Verfahrens weisen eine Reihe von Vorteilen auf. Über ein geeignetes Entropie-basiertes Abstandsmaß wird eine Zusammenfassung von zu codierenden Blöcken des Datenstroms zu Clustern mit ähnlicher Häufigkeitsverteilung der Symbole erreicht. Hierdurch kann eine effiziente Entropiecodierung des Datenstroms über entsprechende, für die Cluster ermittelte Code-Tabellen erreicht werden. Dabei beruht die Bestimmung der Cluster auf einem k-means-Verfahren, welches bislang im Bereich der Datencodierung nicht eingesetzt wurde. Im Vergleich zu herkömmlichen Verfahren, bei denen der Datenstrom mit einem vorab generierten Satz von Code-Tabellen codiert wird, können bessere Kompressionsergebnisse erreicht werden.

## Patentansprüche

1. Verfahren zur Codierung eines Datenstroms (DS), wobei der Datenstrom (DS) eine Vielzahl von Zeichen umfasst, welche Symbole (S) aus einem Alphabet sind, wobei die Zeichen des Datenstroms (DS) in eine Mehrzahl von Blöcken (B) zusammengefasst sind und die Blöcke (B) basierend auf einer für den jeweiligen Block (B) gültigen Code-Tabelle (CT) entropiecodiert werden, wobei

   - die Blöcke (B) über eine Iteration (IT) einer Mehrzahl von Clustern (CL) basierend auf einem Abstandsmaß (d) zugeordnet werden, welches derart definiert ist, dass das Abstandsmaß (d) zwischen einem Block (B) und einem Cluster (CL) umso kleiner ist, je geringer die Veränderung der Entropie (ET) des Clusters (CL) bei der Hinzunahme des Blocks (B) zu dem Cluster (CL) ist, wobei in einem jeweiligen Iterationsschritt der Iteration (IT) eine Neuzuordnung der Blöcke (B) zu den Clustern (CL) erfolgt, indem die Blöcke (B) jeweils dem Cluster (CL) mit dem geringsten Abstandsmaß (d) zwischen Block (B) und Cluster (CL) zugeordnet werden;
   - den durch die Iteration (IT) bestimmten Clustern (CL) jeweils eine Code-Tabelle (CT) zugeordnet wird, welche basierend auf der Häufigkeitsverteilung der Symbole (S) in zumindest einem Teil der in dem jeweiligen Cluster (CL) enthaltenen Blöcke (B) bestimmt wird und für alle Blöcke (B) des jeweiligen Clusters (CL) gültig ist;

   **dadurch gekennzeichnet, dass**
   die Iteration (IT) derart initialisiert wird, dass eine Mehrzahl von Clustern (CL) aus jeweils einem Block ermittelt wird und anschließend die restlichen Blöcke (B) jeweils dem Cluster (CL) mit dem geringsten Abstandsmaß (d) zwischen Block (B) und Cluster (CL) zugeordnet werden, wobei bei der Initialisierung der Iteration zunächst der Block (B) mit der kleinsten Entropie (ET) im Datenstrom (DS) ermittelt wird und ein Cluster (CL) aus diesem Block (B) gebildet wird, wobei anschließend schrittweise Blöcke (B) ermittelt werden, deren minimales Abstandsmaß (d) zu den bereits vorhandenen Clustern (CL) maximal ist, wobei für einen ermittelten Block (B) ein weiterer Cluster (CL) aus diesem ermittelten Block (B) gebildet wird, bis die Mehrzahl von Clustern (CL) aus jeweils einem Block (B) vorliegt.

2. Verfahren nach Anspruch 1, **dadurch gekennzeichnet, dass** in jedem Iterationsschritt die Gesamtentropie (TE) als Summe der Entropien aller Cluster (CL) bestimmt wird und die Iteration (IT) abgebrochen wird, wenn der Unterschied zwischen der im jeweiligen Iterationsschritt bestimmten Gesamtentropie (TE) und der im vorhergehenden Iterationsschritt bestimmten Gesamtentropie (TE) geringer als eine vorbestimmte Schwelle ist.

3. Verfahren nach einem der vorhergehenden Ansprüche, **dadurch gekennzeichnet, dass** die Iteration (IT) abgebrochen wird, wenn eine maximale Anzahl an Iterationsschritten überschritten wird.

4. Verfahren nach einem der vorhergehenden Ansprüche, **dadurch gekennzeichnet, dass** die Blöcke (B) mit einer Huffman-Codierung entropiecodiert werden.

5. Verfahren nach einem der vorhergehenden Ansprüche, **dadurch gekennzeichnet, dass** der Datenstrom (DS) Software-Aktualisierungs-Daten, insbesondere für ein Mobilfunktelefon, umfasst.

6. Codiereinrichtung zur Codierung eines Datenstroms, wobei der Datenstrom (DS) eine Vielzahl von Zeichen umfasst, welche Symbole (S) aus einem Alphabet sind, wobei die Zeichen des Datenstroms (DS) in eine Mehrzahl von Blöcken (B) zusammengefasst sind, wobei die Codiereinrichtung (CM) zur Entropiecodierung der Blöcke (B) basierend auf einer für den jeweiligen Block (B) gültigen Code-Tabelle (CT) vorgesehen ist, wobei die Codiereinrichtung (CM) umfasst:

- ein erstes Mittel (M1), um die Blöcke (B) über eine Iteration einer Mehrzahl von Clustern (CL) basierend auf einem Abstandsmaß (d) zuzuordnen, welches derart definiert ist, dass das Abstandsmaß (d) zwischen einem Block (B) und einem Cluster (CL) umso kleiner ist, je geringer die Veränderung der Entropie (ET) des Clusters (CL) bei der Hinzunahme des Blocks (B) zu dem Cluster (CL) ist, wobei in einem jeweiligen Iterationsschritt der Iteration (IT) eine Neuzuordnung der Blöcke (B) zu den Clustern (CL) erfolgt, indem die Blöcke (B) jeweils dem Cluster (CL) mit dem geringsten Abstand (d) zwischen Block (B) und Cluster (CL) zugeordnet werden;
- ein zweites Mittel (M2), um den durch die Iteration (IT) bestimmten Clustern (CL) jeweils eine Code-Tabelle (CT) zuzuordnen, welche mit dem zweiten Mittel (M2) basierend auf der Häufigkeitsverteilung der Symbole (S) in zumindest einem Teil der in dem jeweiligen Cluster (CL) enthaltenen Blöcke (B) bestimmt wird und für alle Blöcke (B) des jeweiligen Clusters (CL) gültig ist,

**dadurch gekennzeichnet, dass**
die Codiereinrichtung derart ausgestaltet ist, dass die Iteration (IT) derart initialisiert wird, dass eine Mehrzahl von Clustern (CL) aus jeweils einem Block ermittelt wird und anschließend die restlichen Blöcke (B) jeweils dem Cluster (CL) mit dem geringsten Abstandsmaß (d) zwischen Block (B) und Cluster (CL) zugeordnet werden, wobei bei der Initialisierung der Iteration zunächst der Block (B) mit der kleinsten Entropie (ET) im Datenstrom (DS) ermittelt wird und ein Cluster (CL) aus diesem Block (B) gebildet wird, wobei anschließend schrittweise Blöcke (B) ermittelt werden, deren minimales Abstandsmaß (d) zu den bereits vorhandenen Clustern (CL) maximal ist, wobei für einen ermittelten Block (B) ein weiterer Cluster (CL) aus diesem ermittelten Block (B) gebildet wird, bis die Mehrzahl von Clustern (CL) aus jeweils einem Block (B) vorliegt.

7. Codiereinrichtung nach Anspruch 6, welche zur Durchführung eines Verfahrens nach einem der Ansprüche 2 bis 5 ausgestaltet ist.

8. Verfahren zum Aussenden eines Datenstroms (DS), **dadurch gekennzeichnet, dass** der Datenstrom (DS) mit einem Verfahren nach einem der Ansprüche 1 bis 5 codiert wird und der codierte Datenstrom (CD) sowie die Code-Tabellen (CT) für die Mehrzahl von Clustern (CL) und die Information, für welche Blöcke (B) die Code-Tabellen (CT) gültig sind, ausgesendet werden.

9. Sendevorrichtung zum Aussenden eines Datenstroms (DS), umfassend eine Codiereinrichtung (CM) nach Anspruch 6 oder 7 sowie ein Mittel (SM) zum Aussenden des mit der Codiereinrichtung (CM) codierten Datenstroms (CD) und der Code-Tabellen (CT) für die Mehrzahl von Clustern (CL) und der Information, für welche Blöcke (B) die Code-Tabellen (CT) gültig sind.

10. Verfahren zur Übertragung eines Datenstroms, **dadurch gekennzeichnet, dass** der Datenstrom (DS) mit dem Verfahren nach Anspruch 8 ausgesendet wird und von einer Empfangsvorrichtung (RE) empfangen wird, welche den codierten Datenstrom (CD) mit Hilfe der Code-Tabellen (CT) für die Mehrzahl von Clustern (CL) und der Information, für welche Blöcke (B) die Code-Tabellen (CT) gültig sind, decodiert.

11. Vorrichtung zur Übertragung eines Datenstroms (DS), umfassend eine Sendevorrichtung (SE) nach Anspruch 9 zum Aussenden des Datenstroms (DS) sowie eine Empfangsvorrichtung (RE) mit einem Empfangsmittel (RM) zum Empfang des codierten Datenstroms (CD) und der Code-Tabellen (CT) für die Mehrzahl von Clustern (CL) und der Information, für welche Blöcke (B) die Code-Tabellen (CT) gültig sind, und mit einer Decodiereinrichtung (DM) zum Decodieren des codierten Datenstroms (CD) mit Hilfe der Code-Tabellen (CT) und der Information, für welche Blöcke (B) die Code-Tabellen (CT) gültig sind.

**Claims**

1. Method for coding a data stream (DS), the data stream (DS) comprising a multiplicity of characters which are symbols (S) from an alphabet, the characters in the data stream (DS) being combined to form a plurality of blocks (B), and the blocks (B) being entropy-coded on the basis of a code table (CT) valid for the respective block (B), wherein

- the blocks (B) are assigned to a plurality of clusters (CL) using an iteration (IT) on the basis of a clearance (d) which is defined in such a manner that the clearance (d) between a block (B) and a cluster (CL) is smaller the smaller the change in the entropy (ET) of the cluster (CL) when adding the block (B) to the cluster (CL), the blocks (B) being reassigned to the clusters (CL) in a respective iteration step of the iteration (IT) by respectively assigning the blocks (B) to the cluster (CL) with the smallest clearance (d) between the block (B) and the cluster (CL);
- a code table (CT) is respectively assigned to the clusters (CL) determined by the iteration (IT), which code table is determined on the basis of the frequency distribution of the symbols (S) in at least some of the blocks (B) contained in the respective cluster (CL) and is valid for all blocks (B) in the respective cluster (CL);

**characterized in that**
the iteration (IT) is initialized in such a manner that a plurality of clusters (CL) each comprising a block are determined and the remaining blocks (B) are then respectively assigned to the cluster (CL) with the smallest clearance (d) between the block (B) and the cluster (CL), wherein the block (B) with the smallest entropy (ET) in the data stream (DS) is first of all determined when initializing the iteration and a cluster (CL) is formed from this block (B), blocks (B) whose minimum clearance (d) from the already existing clusters (CL) is at a maximum then gradually being determined, a further cluster (CL) being formed, for a determined block (B), from this determined block (B) until the plurality of clusters (CL) each comprising a block (B) are present.

2. Method according to Claim 1, **characterized in that** the total entropy (TE) is determined as the sum of the entropies of all clusters (CL) in each iteration step, and the iteration (IT) is terminated if the difference between the total entropy (TE) determined in the respective iteration step and the total entropy (TE) determined in the preceding iteration step is lower than a predetermined threshold.

3. Method according to one of the preceding claims, **characterized in that** the iteration (IT) is terminated if a maximum number of iteration steps is exceeded.

4. Method according to one of the preceding claims, **characterized in that** the blocks (B) are entropy-coded using Huffman coding.

5. Method according to one of the preceding claims, **characterized in that** the data stream (DS) comprises software update data, in particular for a mobile radio telephone.

6. Coding device for coding a data stream, the data stream (DS) comprising a multiplicity of characters which are symbols (S) from an alphabet, the characters in the data stream (DS) being combined to form a plurality of blocks (B), the coding device (CM) being intended to subject the blocks (B) to entropy coding on the basis of a code table (CT) valid for the respective block (B),
wherein
the coding device (CM) comprises:

- a first means (M1) for assigning the blocks (B) to a plurality of clusters (CL) using an iteration on the basis of a clearance (d) which is defined in such a manner that the clearance (d) between a block (B) and a cluster (CL) is smaller the smaller the change in the entropy (ET) of the cluster (CL) when adding the block (B) to the cluster (CL), the blocks (B) being reassigned to the clusters (CL) in a respective iteration step of the iteration (IT) by respectively assigning the blocks (B) to the cluster (CL) with the shortest distance (d) between the block (B) and the cluster (CL);
- a second means (M2) for respectively assigning a code table (CT) to the clusters (CL) determined by the iteration (IT), which code table is determined using the second means (M2) on the basis of the frequency distribution of the symbols (S) in at least some of the blocks (B) contained in the respective cluster (CL) and is valid for all blocks (B) in the respective cluster (CL),

**characterized in that**
the coding device is configured in such a manner that the iteration (IT) is initialized in such a manner that a plurality of clusters (CL) each comprising a block are determined and the remaining blocks (B) are then respectively assigned to the cluster (CL) with the smallest clearance (d) between the block (B) and the cluster (CL), wherein the block (B) with the smallest entropy (ET) in the data stream (DS) is first of all determined when initializing the iteration and a cluster (CL) is formed from this block (B), blocks (B) whose minimum clearance (d) from the already existing clusters (CL) is at a maximum then gradually being determined, a further cluster (CL) being formed, for a determined block (B), from this determined block (B) until the plurality of clusters (CL) each comprising a block (B) are present.

7. Coding device according to Claim 6, which is designed to carry out a method according to one of Claims 2 to 5.

8. Method for emitting a data stream (DS), **characterized in that** the data stream (DS) is coded using a method according to one of Claims 1 to 5 and the coded data stream (CD) and the code tables (CT) for the plurality of clusters (CL) and the information relating to the blocks (B) for which the code tables (CT) are valid are emitted.

9. Transmitting apparatus for emitting a data stream (DS), comprising a coding device (CM) according to Claim 6 or 7 and a means (SM) for emitting the data stream (CD) coded using the coding device (CM) and the code tables (CT) for the plurality of clusters (CL) and the information relating to the blocks (B) for which the code tables (CT) are valid.

10. Method for transmitting a data stream, **characterized in that** the data stream (DS) is emitted using the method according to Claim 8 and is received by a receiving apparatus (RE) which decodes the coded data stream (CD) with the aid of the code tables (CT) for the plurality of clusters (CL) and the information relating to the blocks (B) for which the code tables (CT) are valid.

11. Apparatus for transmitting a data stream (DS), comprising a transmitting apparatus (SE) according to Claim 9 for emitting the data stream (DS) and a receiving apparatus (RE) with a receiving means (RM) for receiving the coded data stream (CD) and the code tables (CT) for the plurality of clusters (CL) and the information relating to the blocks (B) for which the code tables (CT) are valid, and having a decoding device (DM) for decoding the coded data stream (CD) with the aid of the code tables (CT) and the information relating to the blocks (B) for which the code tables (CT) are valid.

## Revendications

1. Procédé de codage d'un flux de données (DS), le flux de données (DS) comprenant une pluralité de caractères qui sont des symboles (S) d'un alphabet, les caractères du flux de données (DS) étant regroupés en une pluralité de blocs (B) et les blocs (B) étant codés par entropie sur la base d'un tableau de codes (CT) valable pour le bloc (B) respectif,

   - les blocs (B) étant, par le biais d'une itération (IT), associés à une pluralité de clusters (CL) sur la base d'une mesure de distance (d) qui est définie de telle sorte que la mesure de distance (d) entre un bloc (B) et un cluster (CL) est d'autant plus petite que la modification de l'entropie (ET) du cluster (CL) à l'ajout du bloc (B) au cluster (CL) est faible, une nouvelle association des blocs (B) aux clusters (CL) ayant lieu à une étape d'itération respective de l'itération (IT) par association des blocs (B) respectivement au cluster (CL) ayant la plus faible mesure de distance (d) entre bloc (B) et cluster (CL) ;
   - aux clusters (CL) déterminés par l'itération (IT) étant associé, respectivement, un tableau de codes (CT) qui est déterminé sur la base de la fréquence de distribution des symboles (S) dans au moins une partie des blocs (B) contenus dans le cluster respectif (CL) et qui est valable pour tous les blocs (B) du cluster respectif (CL) ;

   **caractérisé en ce que**
   l'itération (IT) est initialisée de telle sorte qu'une pluralité de clusters (CL) est déterminée à partir de respectivement un bloc et ensuite les blocs restants (B) sont respectivement associés au cluster (CL) avec la plus faible mesure de distance (d) entre le bloc (B) et le cluster (CL), lors de l'initialisation de l'itération, tout d'abord, le bloc (B) avec la plus petite entropie (ET) étant déterminé dans le flux de données (DS) et un cluster (CL) étant formé à partir de ce bloc (B), ensuite, des blocs (B) dont la mesure de distance minimale (d) par rapport aux clusters (CL) déjà existants est maximale étant déterminés progressivement, pour un bloc (B) déterminé étant formé un autre cluster (CL) à partir de ce bloc (B) déterminé jusqu'à obtention de la pluralité de clusters (CL) à partir de respectivement un bloc (B).

2. Procédé selon la revendication 1, **caractérisé en ce que**, à chaque étape d'itération, l'entropie totale (TE) est déterminée comme étant la somme des entropies de tous les clusters (CL) et l'itération (IT) est interrompue lorsque la différence entre l'entropie totale (TE) déterminée à l'étape d'itération respective et l'entropie totale (TE) déterminée à l'étape d'itération précédente est inférieure à un seuil prédéfini.

3. Procédé selon l'une des revendications précédentes, **caractérisé en ce que** l'itération (IT) est interrompue lorsqu'un nombre maximal d'étapes d'itération est dépassé.

**4.** Procédé selon l'une des revendications précédentes, **caractérisé en ce que** les blocs {B} sont codés par entropie au moyen d'un codage de Huffman.

**5.** Procédé selon l'une des revendications précédentes, **caractérisé en ce que** le flux de données (DS) comprend des données de mise à jour de logiciel, en particulier pour un téléphone mobile.

**6.** Dispositif de codage pour coder un flux de données, le flux de données (DS) comprenant une pluralité de caractères qui sont des symboles (S) d'un alphabet, les caractères du flux de données (DS) étant regroupés en une pluralité de blocs (B), le dispositif de codage (CM) pour le codage et les blocs (B) étant codés par entropie sur la base d'un tableau de codes (CT) valable pour le bloc (B) respectif, le dispositif de codage (CM) étant prévu pour le codage entropique des blocs (B) sur la base d'un tableau de codes (CT) valable pour le bloc (B) respectif, le dispositif de codage (CM) comprenant :

- un premier moyen (M1) pour associer les blocs (B), par le biais d'une itération, à une pluralité de clusters (CL) sur la base d'une mesure de distance (d) qui est définie de telle sorte que la mesure de distance (d) entre un bloc (B) et un cluster (CL) est d'autant plus petite que la modification de l'entropie (ET) du cluster (CL) à l'ajout du bloc (B) au cluster (CL) est faible, une nouvelle association des blocs (B) aux clusters (CL) ayant lieu à une étape d'itération respective de l'itération (IT) par association des blocs (B) respectivement au cluster (CL) ayant la plus faible mesure de distance (d) entre bloc (B) et cluster (CL) ;
- un deuxième moyen (M2) pour associer aux clusters (CL) déterminés par l'itération (IT) respectivement un tableau de codes (CT) qui est déterminé au moyen du deuxième moyen (M2) sur la base de la fréquence de distribution des symboles (S) dans au moins une partie des blocs (B) contenus dans le cluster respectif (CL) et qui est valable pour tous les blocs (B) du cluster respectif (CL),

**caractérisé en ce que**
le dispositif de codage est réalisé de telle sorte que l'itération (IT) est initialisée de telle sorte qu'une pluralité de clusters (CL) est déterminée à partir de respectivement un bloc et ensuite les blocs restants (B) sont respectivement associés au cluster (CL) avec la plus faible mesure de distance (d) entre le bloc (B) et le cluster (CL), lors de l'initialisation de l'itération, tout d'abord, le bloc (B) avec la plus petite entropie (ET) étant déterminé dans le flux de données (DS) et un cluster (CL) étant formé à partir de ce bloc (B), ensuite, des blocs (B) dont la mesure de distance minimale (d) par rapport aux clusters (CL) déjà existants est maximale étant déterminés progressivement, pour un bloc (B) déterminé étant formé un autre cluster (CL) à partir de ce bloc (B) déterminé jusqu'à obtention de la pluralité de clusters (CL) à partir de respectivement un bloc (B).

**7.** Dispositif de codage selon la revendication 6, lequel est réalisé pour exécuter un procédé selon l'une des revendications 2 à 5.

**8.** Procédé pour émettre un flux de données (DS), **caractérisé en ce que** le flux de données (DS) est codé au moyen d'un procédé selon l'une des revendications 1 à 5 et **en ce que** sont émis le flux de données codé (CD) ainsi que les tableaux de codes (CT) pour la pluralité de clusters (CL) et l'information indiquant pour quels blocs (B) les tableaux de codes (CT) sont valables.

**9.** Dispositif émetteur pour émettre un flux de données (DS), comprenant un dispositif de codage (CM) selon la revendication 6 ou 7 ainsi qu'un moyen (SM) pour émettre le flux de données (CD) codé au moyen du dispositif de codage (CM) et les tableaux de codes (CT) pour la pluralité de clusters (CL) et l'information indiquant pour quels blocs (B) les tableaux de codes (CT) sont valables.

**10.** Procédé de transmission d'un flux de données, **caractérisé en ce que** le flux de données (DS) est émis au moyen du procédé selon la revendication 8 et est reçu par un dispositif récepteur (RE) qui décode le flux de données codé (CD) à l'aide des tableaux de codes (CT) pour la pluralité de clusters (CL) et de l'information indiquant pour quels blocs (B) les tableaux de codes (CT) sont valables.

**11.** Dispositif de transmission d'un flux de données (DS), comprenant un dispositif émetteur (SE) selon la revendication 9 pour émettre le flux de données (DS) ainsi qu'un dispositif récepteur (RE) avec un moyen de réception (RM) pour recevoir le flux de données codé (CD) et les tableaux de codes (CT) pour la pluralité de clusters (CL) et l'information indiquant pour quels blocs (B) les tableaux de codes (CT) sont valables, et un dispositif de décodage (DM) pour décoder le flux de données codé (CD) à l'aide des tableaux de codes (CT) et de l'information indiquant pour quels blocs (B) les tableaux de codes (CT) sont valables.

## FIG 1

DS (S, B)

d, ET

S1

S2

IT

P

TE

CL, CT

## FIG 2

RM    RE    DM

DS

M1    M2    SM

CM

CD
IN

U

RM    DM

DS

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **FARSHID GOLCHIN et al.** Minimum-entropy clustering and ist application to lossless image coding. *PROC. OF INT. CONF. ON IMAGE PROCESSING,* 26. Oktober 1997, vol. 2, 262-265